# EUROPÄISCHE PATENTANMELDUNG

(11) **EP 0 566 896 A1**
(43) Veröffentlichungstag der Anmeldung: **27.10.1993**
(21) Anmeldenummer: 93104968.8
(22) Anmeldetag: 25.03.1993
(51) Int. Cl.: C08F 297/02, G03F 7/033

(54) **Amphiphile, elastomere Blockcopolymerisate für die Herstellung von Flachdruckplatten**

(30) Priorität: 04.04.1992 DE 4211393
(71) Anmelder: HOECHST AKTIENGESELLSCHAFT, D-65926 Frankfurt am Main (DE)
(72) Erfinder: Gries, Willi-Kurt, Dr., W-6200 Wiesbaden (DE)

(57) **Zusammenfassung**

Die Erfindung betrifft amphiphile, elastomere Blockcopolymerisate, bestehend aus
- A: 20 bis 99 Gew.-% eines hydrophoben weichen Blocks mit einer Glastemperatur T_{g} von unter -30 °C,
- B: 30 bis 60 Gew.-% eines hydrophilen harten Blocks mit einer Glastemperatur T_{g} von über +30 °C, der saure Gruppen, vorzugsweise Carboxygruppen, enthält,
- C: 0 bis 79 Gew.-% eines hydrophoben harten Blocks mit einer Glastemperatur T_{g} von über +50 °C und
- X: einer Einheit, gebildet aus einer Verbindung mit zwei oder mehreren Vinyl- oder Isopropenylgruppen oder einem aus solchen Verbindungen entstandenen Homopolymerisat-Block, der in der Regel verzweigt bzw. vernetzt ist, wobei das Verhältnis der Gewichtsprozente der Blöcke A zur Summe der Gewichtsprozente der Blöcke B und C 1:0,5 bis 1:19 beträgt.

Diese Blockcopolymerisate eignen sich als elastomere Bindemittel in lichthärtbaren elastomeren Gemischen zur Beschichtung von Flachdruckplatten.

## Beschreibung

Die Erfindung betrifft ein Verfahren zur Herstellung von Blockcopolymerisaten sowie deren Verwendung als Bindemittel in lichthärtbaren, elastomeren, negativ arbeitenden Gemischen und ein daraus erhältliches Aufzeichnungsmaterial, das für die Herstellung von Flachdruckplatten geeignet ist.

In der DE-A 40 32 238 sind Blockcopolymere beschrieben, die aus A) hydrophoben weichen Blöcken, B) hydrophilen harten Blöcken, die saure Gruppen enthalten, C) hydrophoben harten Blöcken und X) einem Block aus Verbindungen mit mindestens zwei Vinylgruppen bestehen, wobei der Massenanteil des Blocks B) 1 bis 30 Gew.-% beträgt. Diese Blockcopolymere eignen sich als Aufzeichnungsmaterial für Reliefdruckplatten (DE-A 40 32 237).

Aus den DE-A 15 22 362 und 19 17 917 (= US-A 3 630 746) sind photopolymerisierbare Gemische bekannt, die wasserlösliche Bindemittel enthalten. Diese Gemische lassen sich zwar in der Regel sehr leicht und schleierfrei entwickeln, sie haben jedoch den Nachteil, daß beim Flachdruck die gehärteten Bildstellen, die das wasserlösliche Bindemittel enthalten, leichter vom Feuchtwasser benetzt und im Verlauf höherer Druckauflagen davon angegriffen werden.

Gemische dieser Art sind auch in der DE-A 20 53 363 (= US-A 3 732 105) beschrieben. Sie enthalten als Bindemittel Umsetzungsprodukte aus einem Hydroxyl- oder Aminogruppen enthaltenden Polymeren mit mindestens einem gesättigten Alkyl-, Alkoxy-, Aryl- oder Aryloxysulfonylisocyanat. Das Bindemittel wird in Kombination mit Diazoniumsalz-Kondensationsprodukten oder photopolymerisierbaren Gemischen zu lichtempfindlichen Schichten verarbeitet. Die dabei erhaltenen Gemische lassen sich allerdings nur dann wäßrig-alkalisch entwickeln, wenn die eingesetzten Bindemittel hohe Säurezahlen aufweisen, wodurch die Abriebfestigkeit und auch die Druckeigenschaften der gehärteten Schichten nachteilig beeinflußt werden.

Der Einsatz dienhaltiger Komponenten in lichthärtbaren Gemischen für den Einsatz in Flachdruckplatten und Photoresists ist in den DE-A 33 28 019 (= US-A 4 568 628), EP-A 0 140 353 (= US-A 4 643 963) und JP-A 59-206825 beschrieben. Die z. T. elastischen Bindemittelkomponenten werden dabei in Form einer Dispersion eines carboxylgruppenhaltiges Butadien/Methacrylat- oder eines Dicyclopentadien/Maleinsäureanhydrid-Copolymeren verwendet. In diesen Systemen ist eine wäßrige Entschichtbarkeit nur dann gewährleistet, wenn hohe Anteile hydrophiler Funktionalitäten im Bindemittel enthalten sind, so daß auch hierbei Abriebfestigkeit und Druckeigenschaften beeinträchtigt werden.

Die Aufgabe der vorliegenden Erfindung besteht darin, die Blockcopolymerisate gemäß der DE-A 40 32 238 so abzuwandeln, daß sie auch für Flachdruckplatten eingesetzt werden können. Diese Aufgabe wird gelöst durch das Einhalten eines bestimmten Gewichtsverhältnisses zwischen den harten und den weichen Blöcken.

Gegenstand der Erfindung sind somit amphiphile, elastomere Blockcopolymerisate, bestehend aus
- A: 20 bis 99 Gew.-% eines hydrophoben weichen Blocks mit einer Glastemperatur T_{g} von unter -30 °C,
- B: 30 bis 60 Gew.-% eines hydrophilen harten Blocks mit einer Glastemperatur T_{g} von über +30 °C, der saure Gruppen, vorzugsweise Carboxygruppen, enthält,
- C: 0 bis 79 Gew.-% eines hydrophoben harten Blocks mit einer Glastemperatur T_{g} von über +50 °C und
- X: einer Einheit, gebildet aus einer Verbindung mit zwei oder mehreren Vinyl- oder Isopropenylgruppen oder einem aus solchen Verbindungen entstandenen Homopolymerisat-Block, der in der Regel verzweigt bzw. vernetzt ist, wobei das Verhältnis der Gewichtsprozente der Blöcke A zur Summe der Gewichtsprozente der Blöcke B und C 1:0,5 bis 1:19 beträgt.

Gegenstand der Erfindung ist weiterhin ein Verfahren zur Herstellung dieser Blockcopolymerisate sowie deren Verwendung als Bindemittel in lichthärtbaren elastomeren Gemischen zur Beschichtung von Flachdruckplatten.

Diese Blockcopolymerisate können auf mannigfache Weise aufgebaut sein, je nachdem, welche und wie viele dieser Segmente in dem Copolymerisat enthalten sind und wie diese Segmente miteinander verknüpft sind. Diese Blockcopolymerisate können beispielsweise folgende Strukturen haben: A-B, C-A-B, C-A-C-B, AₙXBₙ, (A-B)ₙX, CₙX(A-B)ₙ, (C-A)ₙXBₙ, (C-A-B)ₙX, CₙX(A-C-B)ₙ, (C-A)ₙX(C-B)ₙ, (C-A-C)ₙXBₙ und (C-A-C-B)ₙX. Ferner sind symmetrische B-A-B- und B-C-A-C-B-Blockcopolymerisate und verzweigte Vertreter entsprechend X(B-A-B)ₙX, BₙXAₙXBₙ, X(B-C-A-C-B)ₙX, (B-C)ₙXAₙX(C-B)ₙ sowie BₙX(C-A-C)ₙXBₙ als Bindemittel verwendbar.

In diesen Formeln haben die Symbole A, B, C und X die oben genannten Bedeutungen, und n gibt das Verhältnis von A/B/C-Homopolymer-Blöcken zu dem Homopolymerisat-Block X an.

Als Monomere für die Blockpolymerisate A sind konjugierte Diene, wie 1,3-Butadien, Isopren, 2,3-Dimethyl-1,3-butadien, 1,3-Pentadien, 2-Methyl-3-ethyl-1,3-butadien, 3-Methyl-1,3-Pentadien, 2-Methyl-3-ethyl-1,3-pentadien, 2-Ethyl-1,3-Pentadien, 1,3-Hexadien, 2-Methyl-1,3-hexadien, 1,3-Heptadien, 1,3-Octadien, 3,4-Dimethyl-1,3-hexadien und 2-Phenyl-1,3-butadien, in Betracht. Der Einsatz von Gemischen geeigneter Diene bzw. die Anwendung anderer anionisch polymerisierbarer konjugierter Diene mit 4 bis 12 Kohlenstoffatomen kommen ebenfalls in Betracht. Bevorzugt werden Isopren und 1,3-Butadien verwendet.

Die Blöcke B resultieren bevorzugt aus α,β-ethylenisch ungesättigten Carbonsäuren wie Maleinsäure, Fumarsäure, Itaconsäure, Acrylsäure, Methacrylsäure und Crotonsäure. Andere Carbonsäuren mit in der Elektronendichte reduzierten Vinyleinheiten, wie z. B. Vinylbenzoesäure, können ebenfalls als Ausgangsmaterialien dienen.

Als Monomere für die Segmente C sind Vinylaromaten, insbesondere Styrol, Alkylstyrol oder Vinylnaphthalin geeignet, wobei Styrol besonders bevorzugt ist.

Als Verbindungen für X kommen Monomere in Frage, die mindestens zwei Vinyl- oder Isopropenylgruppen enthalten. Vorteilhaft werden hier Di- und Trivinylbenzol sowie Verbindungen mit mindestens zwei Methacryloyloxy-Gruppen verwendet. Besonders bevorzugt sind 1,4-Divinylbenzol, 1,3-Diisopropenylbenzol, Ethylenglykoldimethacrylat und Trimethylolpropantrimethacrylat.

Die Herstellung der beschriebenen Blockpolymerisate erfolgt nach an sich bekannten Methoden. Verwiesen sei hier auf G. Sylvester und P. Müller in Houben-Weyl-Müller, Methoden der Organischen Chemie E 20/2, 798ff. (1987) und G. Schröder in Houben-Weyl-Müller, Methoden der Organischen Chemie E20/2, 1141ff. (1987). Verfahren zum Schutz von Carboxylgruppen sind in T. W. Greene, Protective Groups in Organic Synthesis, Wiley Interscience, New York 1981, S. 168/169, beschrieben.

Zum Start der anionischen Polymerisation werden die üblichen lithiumorganischen Verbindungen R-Li verwendet, wobei unter R aliphatische, cycloaliphatische, aromatische oder gemischt aliphatisch aromatische Reste verstanden werden. Besonders erwähnenswert sind u. a. Methyllithium, Ethyllithium, (n-, sec.-, tert. -) Butyllithium, Isopropyllithium, Cyclohexyllithium, Phenyllithium und p-Tolyllithium. Außerdem können bifunktionelle, in unpolaren Medien aktive Initiatoren, wie sie beispielsweise durch radikalische Kupplung von Diphenylethen mit Li-Metall entstehen oder durch Reaktion von Diisopropenyl-Benzolen mit Li-organischen Verbindungen gebildet werden, Verwendung finden. Bevorzugt zum Einsatz kommen sec.- bzw. n-BuLi sowie 1,4-Dilithio-1,1,4,4-tetraphenylbutan.

Die Copolymerisation wird unter den für die Handhabung von extrem feuchtigkeits- und sauerstoffempfindlichen Reagenzien üblichen Bedingungen durchgeführt, d. h. insbesondere, daß unter getrockneter Inertgasatmosphäre, z. B. unter einer Stickstoff- oder Argonatmosphäre, gearbeitet werden muß. Als Lösemittel werden aliphatische, cycloaliphatische und aromatische Kohlenwasserstoffe, wie Isobutan, n-Pentan, Isooctan, Cyclopentan, Cyclohexan, Cycloheptan, Benzol, Toluol oder Xylol sowie Gemische dieser Solventien eingesetzt. Es ist häufig zweckmäßig, in Gegenwart dipolarer, aprotischer Lösemittel zu arbeiten, um eine regioselektive Reaktion der Monomeren zu gewährleisten und so den Anteil an Produkten aus Nebenreaktionen gering zu halten. (Eine Reaktion wird als "regioselektiv" bezeichnet, wenn von zwei oder mehreren zur Reaktion befähigten Zentren eines Moleküls eines weit überwiegend oder allein reagiert.) Besonders bevorzugte dipolare, aprotische Lösemittel sind Ether, wie beispielsweise Tetrahydrofuran, Dimethoxyethan oder Methylphenylether. Zur Erzielung bestimmter Eigenschaften der Produkte erweist es sich als günstig, die anionische Copolymerisation in unpolaren, aprotischen Solventien zu beginnen, jedoch mit fortschreitendem Umsatz die Polarität des Solvens durch Zugabe stärker polarer Ether zu erhöhen. Der Volumenanteil der Ether kann dabei bis über 95 % des Gesamtlösemittelvolumens betragen.

Die anionischen Kettenenden der A- bzw. C-Blöcke besitzen häufig eine zu starke Nucleophilie. Vor der weiteren Copolymerisation ist daher eine Reduzierung der Nucleophilie des anionischen Kettenendes zweckmäßig. Dies läßt sich durch den Zusatz von ungesättigten Verbindungen der allgemeinen Formel CH₂=CR¹R² erreichen. R¹ und R² stehen dabei für Aryl- bzw. Alkylarylgruppen, insbesondere jedoch für gegebenenfalls substituierte Phenylgruppen. Doch sind auch 1-Phenyl-1-naphthylethen und seine Derivate brauchbar. Auch Styrole (R¹ = gegebenenfalls substituiertes Phenyl, R² = H oder C₁-C₆-Alkyl) sind geeignet, insbesondere wenn unmittelbar zuvor Styrol-Blöcke eingeführt wurden. Bevorzugt ist jedoch 1,1-Diphenylethen.

Die Blockcopolymerisation wird in bekannter Weise durch sequentielle Addition der verschiedenen Monomere durchgeführt. Die Reaktionsführung erfolgt dabei in der Art, daß die zum Aufbau von Folgeblöcken notwendigen Vinylverbindungen erst nach weitgehendem Umsatz der bereits vorhandenen Monomere zugegeben werden. Die Reaktionstemperatur wird zwischen -80 °C und 120 °C eingestellt. Vorzugsweise variieren die Temperaturen zwischen -20 °C und +20 °C. Es empfiehlt sich die zum Aufbau der B-Blöcke eingesetzten Monomere mindestens bei Raumtemperatur, jedoch besser bei 0 bis 10 °C zu polymerisieren. Nach Beendigung des gewünschten Blockaufbaus können die polymeren Anionen durch Protonenquellen, wie Alkohole, Wasser, Ammoniumchlorid oder HCl, desaktiviert werden.

Die Entfernung der Schutzgruppen erfolgt wahlweise direkt in der Polymerisationsmischung oder nach Resolvatation des ausgefällten Copolymeren. Zur eigentlichen Freisetzung der ursprünglichen Funktionalität werden die gelösten Polymere mit katalytischen Mengen einer starken Säure versetzt und je nach Zusammensetzung auf 40 bis 120 °C erwärmt. Geeignete Säuren sind u. a. alkoholische HCl, Trifluoressigsäure bzw. Sulfonsäuren, wie Benzolsulfonsäure, p-Toluolsulfonsäure oder Camphersulfonsäure. Der Fortgang der Reaktion läßt sich dabei durch Säure/Base-Titration der isolierten Produkte kontrollieren.

Die durch Gelpermeationschromatographie (GPC) bestimmten Molekulargewichte bewegen sich zwischen 2.000 g/mol und 2.000.000 g/mol, vorzugsweise zwischen 15.000 g/mol und 200.000 g/mol.

Die erfindungsgemäßen lichtempfindlichen Gemische enthalten bevorzugt 20 bis 95 Gew.-%, besonders bevorzugt 30 bis 90 Gew.-%, des zuvor beschriebenen Blockcopolymers als Bindemittel entweder ausschließlich oder in Verbindung mit anderen polymeren Materialien. Sie enthalten weiterhin mindestens eine radikalisch polymerisierbare, olefinisch ungesättigte Verbindung sowie mindestens einen Photoinitiator.

Geeignete Monomere mit einer oder mehreren polymerisierbaren olefinischen Doppelbindungen sind insbesondere Ester und Amide der Acryl-, Methacryl-, Fumar- und Maleinsäure sowie Gemische dieser Verbindungen. Zusätzlich können die zur Ester- oder Amidbildung benötigten Alkohole bzw. Amine weitere Funktionalitäten, z. B. Ethereinheiten, Hydroxy-, prim., sek. oder tert. Aminogruppen enthalten. Beispiele für zur Esterbildung geeignete Alkohole sind offenkettige und cyclische Alkanole, wie Butanol, Hexanol, Octanol, Decanol, Dodecanol, Octadecanol, 2-Ethylhexanol, Cyclohexanol oder Borneol, aber auch Hydroxygruppen enthaltende Oligo- oder Polybutadiene und Hydroxygruppen enthaltende Oligo- oder Polyisoprene. Weitere geeignete Alkohole sind Alkandiole, polyfunktionelle Alkohole, und ähnliche Verbindungen, z. B. 1,4-Butandiol oder 1,6-Hexandiol, (Poly)ethylenglykol oder (Poly)propylenglykol, Glycerin, Trimethylolpropan, Butantriol, Pentaerythrit u. a. Die di- oder polyfunktionellen Alkohole können dabei teilweise oder vollständig verestert sein. Weitere Beispiele ungesättigter Verbindungen sind spezielle Ester und Amide der (Meth)acrylsäure, z. B. Dimethylaminoethyl(meth)acrylat, Dimethylaminopropyl(meth)acrylamid, 2-Butylaminoethyl(meth)acrylat, Ethylenbis(meth)acrylamid, Hexamethylenbis(meth)acrylamid, Diethylentriamintris(meth)acrylamid, Hydroxymethyl(meth)acrylamid und Bishydroxyethyl(meth)acrylamid.

Die Menge an Monomeren liegt im allgemeinen bei etwa 5 bis 70 Gew.-%, bevorzugt bei etwa 20 bis 70 Gew.-%, der nichtflüchtigen Bestandteile des Gemisches.

Als Photoinitiatoren für die erfindungsgemäßen Gemische kommen die bekannten Verbindungen in Frage, die eine hinreichende thermische Stabilität bei der Verarbeitung der Aufzeichnungsmaterialien sowie eine ausreichende Radikalbildung bei Belichtung zur Initiierung der Polymerisation der Monomeren aufweisen. Sie sollen Licht im Wellenlängenbereich von ca. 250 nm bis 500 nm unter Bildung von Radikalen absorbieren. Beispiele geeigneter Photoinitiatoren sind Acyloine und deren Derivate wie Benzoin, Benzoinalkylether, 1,2-Diketone und deren Derivate, z. B. Benzil, Benzilacetale wie Benzildimethylketal, Fluorenone, Thioxanthone, mehrkernige Chinone, Acridine und Chinoxaline, ferner Trichlormethyl-s-triazine, 2-Halogenmethyl-4-vinyl-[1,3,4]oxadiazol, mit Trichlormethylgruppen substituierte Halogenoxazole, Trihalogenmethylgruppen enthaltende Carbonylmethylenheterocyclen, Acylphosphinoxid-Verbindungen und andere phosphorhaltige Photoinitiatoren, wie 6-Acyl-6H-dibenzo[c,e][1,2]oxaphosphorin-6-oxide, insbesondere das 6-(2,4,6-Trimethylbenzoyl)-6H-dibenzo[c,e][1,2]oxaphosphorin-6-oxid. Die Photoinitiatoren lassen sich auch in Kombination miteinander oder mit Coinitiatoren bzw. Aktivatoren verwenden, z. B. mit Michlers Keton und seinen Derivaten oder 2-Alkyl-anthrachinonen. Die Menge an Photoinitiator beträgt im allgemeinen etwa 0,1 bis 15 Gew.-%, bevorzugt etwa 0,5 bis 10 Gew.-%, des Aufzeichnungsmaterials.

Oft ist es von Vorteil, dem Gemisch noch weitere Hilfs- und Zusatzstoffe zuzugeben, z. B. solche, die die thermische Polymerisation inhibieren, wie Hydrochinon und seine Derivate, 2,6-Di-tert.-butyl-p-kresol, Nitrophenole, Nitrosamine wie N-Nitrosodiphenylamin oder Salze des N-Nitrosocyclohexylhydroxylamins, z. B. dessen Alkali- oder Aluminiumsalze. Weitere übliche Zusätze sind Wasserstoffdonatoren, Farbstoffe, gefärbte oder ungefärbte Pigmente, Farbbildner, Indikatoren, Weichmacher und Kettenüberträger.

Art und Menge dieser Zusätze richten sich nach dem für das lichtempfindliche Gemisch vorgesehenen Anwendungsgebiet. Dabei ist grundsätzlich zu beachten, daß die beigefügten Stoffe keinen übergroßen Anteil des für die Vernetzung notwendigen aktinischen Lichtes absorbieren und dadurch die praktische Lichtempfindlichkeit herabsetzen.

Gegenstand der Erfindung ist damit auch ein Aufzeichnungsmaterial mit einem Träger und einer lichtempfindlichen Schicht, die das erfindungsgemäße lichtempfindliche Gemisch enthält.

Soll das erfindungsgemäße Gemisch auf ein Trägermaterial durch Gießen, Sprühen oder Eintauchen aufgebracht werden, so wird es zweckmäßig in einem entsprechenden organischen Lösemittel oder Lösemittelgemisch gelöst. Die Art des Auftrags hängt von der gewünschten Schichtdicke ab, wobei die Schichtdicken im allgemeinen zwischen 0,5 und 200 µm liegen.

Als Schichtträger eignen sich z. B. Magnesium, Zink, Kupfer, mechanisch, chemisch und/oder elektrochemisch aufgerauhtes anodisiertes Aluminium, Stahl, aber auch Polyester- bzw. Celluloseacetatfolie, Perlongaze etc., deren Oberfläche bei Bedarf einer Vorbehandlung unterworfen sein kann. Das Trägermaterial kann dabei als endgültiger Schichtträger fungieren oder als temporäres Trägermaterial, von dem die lichtempfindliche Schicht auf das zu bearbeitende Werkstück übertragen wird.

Das erfindungsgemäße Gemisch erfordert nicht unbedingt einen Sauerstoffausschluß bei der Belichtung. Es ist aber im allgemeinen günstig, die Gemische während der Lichtpolymerisation dem Einfluß des Luftsauerstoffs weitgehend zu entziehen. Im Fall der Anwendung des Gemisches in Form dünner Kopierschichten ist es empfehlenswert, einen geeigneten, für Sauerstoff wenig durchlässigen Deckfilm aufzubringen. Dieser kann selbsttragend sein, und vor der Entwicklung der Kopierschicht abgezogen werden. Für diesen Zweck sind z. B. Polyesterfilme geeignet. Der Deckfilm kann auch aus einem Material bestehen, das sich in der Entwicklerflüssigkeit löst oder mindestens an den nicht gehärteten Stellen bei der Entwicklung entfernen läßt. Hierfür geeignete Materialien sind z. B. Polyvinylalkohol, Vinylalkohol/Vinylacetat-Copolymere, Polyvinylpyrrolidon, Vinylpyrrolidon/Vinylacetat-Copolymere, Polyacrylsäure, Butadien/Maleinsäure-Copolymere, Polyvinylmethylether, Polyphosphate, Zucker usw.. Solche Deckschichten haben im allgemeinen eine Dicke von 0,1 bis 10 µm, vorzugsweise von 0,5 bis 5 µm.

Das mit den lichtempfindlichen Gemischen produzierte Aufzeichnungsmaterial dient einerseits zur Herstellung von Bildern auf geeigneten Trägern bzw. Empfangsblättern, andererseits zur Herstellung von Reliefs, die als Druckformen, Siebe, Reservagen und dgl. Anwendung finden. Darüber hinaus ist es aber auch möglich, die lichtempfindlichen Gemische zur Herstellung von durch UV-Strahlung härtbaren Lacken zu verwenden, die als Oberflächenschutz eingesetzt werden können, oder zur Formulierung von UV-härtbaren Druckfarben.

Bevorzugt wird das Gemisch zur Herstellung von Flachdruckformen verwendet, wobei als Trägermaterial insbesondere Aluminium geeignet ist, das in üblicher Weise vorbehandelt wird, z. B. durch mechanisches, chemisches und/oder elektrochemisches Aufrauhen und ggf. anschließende anodische Oxidation. Ein weitere Behandlung dieses Trägermaterials z. B. mit Polyvinylphosphonsäure, Alkalisilikat, Phosphat, Hexafluorozirkonat, Chromat, Borat, Polyacrylamid oder Cellulosederivaten, ist vorteilhaft.

Die Verarbeitung der aus den Gemischen erhaltenen Aufzeichnungsmaterialien erfolgt in bekannter Weise durch bildmäßiges Belichten und Auswaschen der unbelichteten Schichtbereiche mit einem geeigneten Entwickler.

Die Belichtung des Aufzeichnungsmaterials erfolgt in bekannter Weise unter einer Vorlage mit Kopierlichtquellen, die einen möglichst hohen spektralen Anteil im nahen UV-Bereich emittieren. Sie kann auch durch Laserstrahlung erfolgen.

Als Entwicklerlösungen werden neutrale oder bevorzugt alkalische wäßrige Lösungen mit einem pH-Wert im Bereich 8 bis 14, vorzugsweise 8,5 bis 13, verwendet, die Puffersalze, z. B. wasserlösliche Alkaliphosphate, -silikate, -borate, -carbonate, -acetate oder -benzoate, enthalten. Als weitere Bestandteile werden Netzmittel, vorzugsweise anionische Netzmittel, und ggf. wasserlösliche Polymere verwendet. Die Lösung kann auch geringe Mengen, z. B. bis zu 5 Gew.-%, bevorzugt nicht mehr als 2 Gew.-%, an mit Wasser mischbaren organischen Lösemitteln enthalten. Bevorzugt werden schwerflüchtige Lösemittel, z. B. araliphatische Alkohole, deren Dampfdruck bei der Handhabung des Entwicklers nicht ins Gewicht fällt. Die Entwicklung kann in bekannter Weise durch Tauchen, Besprühen, Bürsten oder Tamponieren erfolgen. Anschließend kann das entwickelte Material mit einem Konservierungsmittel behandelt werden.

Die erfindungsgemäßen lichtempfindlichen Aufzeichnungsmaterialien weisen gute Wiedergabeeigenschaften und praxisgerechte Lagerstabilität auf. Sie lassen sich leicht schleierfrei mit Entwicklerlösungen verarbeiten, die praktisch umweltneutral sind.

Von besonderem Vorteil ist die hohe Druckauflage, die mit den aus dem erfindungsgemäßen Material hergestellten Druckformen erreicht wird sowie die gute Farbannahme. Die Druckschablonen weisen ebenfalls eine hohe Resistenz gegenüber alkalischen Entwicklern und anderen Verarbeitungslösungen auf. Zur weiteren Steigerung der Druckauflage können die Platten nach dem Belichten nacherwärmt und bzw. oder die entwickelten Platten nachbelichtet werden.

Die Erfindung wird durch die nachstehenden Beispiele erläutert. Wenn nichts anderes angegeben, stehen %-Angaben für Gew.-%-Angaben.

### Herstellung des Blockcopolymers 1

In einer trockenen, mehrfach evakuierten und mit vorgetrocknetem Stickstoff belüfteten Glasapparatur werden 300 ml wasserfreies Toluol oder alternativ Cyclohexan vorgelegt, 243 mmol trockenes Styrol hinzugefügt und mit 1,65 ml einer 1,6 M n-Butyllithium-Lösung in Hexan versetzt. Nach kurzer Zeit kommt die Polymerisation in Gang. Danach wird die Lösung noch 1 h im Wasserbad gerührt. Anschließend werden 1,12 mol Isopren hinzugefügt, im Wasserbad 3 h zur Reaktion gebracht, weitere 243 mmol Styrol zugegeben und ebenfalls eine Stunde polymerisiert. Danach werden bezogen auf den Starter 2 Äquivalente 1,1-Diphenylethen addiert, mit 300 ml Tetrahydrofuran verdünnt und mit einer Kochsalz/Eiswasser-Mischung abgekühlt. Zur 0 bis 5 °C kalten Reaktionsmischung werden 370 mmol t-Butylmethacrylat zugegeben, noch 1 h im Eisbad nachgerührt und mit 1 ml Methanol terminiert. Die Reaktionslösung wird anschließend in das 10-fache Volumen Methanol eingesprüht. Das ausgefallene Polymere wird abgesaugt, gewaschen und getrocknet. Zur Entfernung der t-Butyl-Schutzgruppe wird das isolierte Material in Toluol gelöst, mit 5 Gew.-% p-Toluolsulfonsäure - bezogen auf den t-Butylmethacrylat-Anteil - versetzt, auf 80 °C erwärmt und 6 h bei dieser Temperatur gehalten. Nach dem Abkühlen wird mit MeOH ausgefällt, gewaschen und im Vakuum bei Raumtemperatur getrocknet.

Das so erhaltene Produkt hat folgende Kenndaten: Gehalt an Styrol (S), Isopren (I) und Methacrylsäure (MAA) = S-I-S-MAA (16/48/16/20 %), Ausbeute = 95/97% GPC (THF): Mp (UV) = 105.000, D = 1,97, Säurezahl = 106 mg KOH/g, Iodzahl = 154 g I₂/100 g.

### Herstellung der Blockcopolymere 2 bis 5

In analoger Weise werden die Blockcopolymeren 2 bis 5 hergestellt, die folgende Kenndaten aufweisen:
**2** S-I-S-MAA (32/16/32/20 %), Ausbeute = 99/100 %, GPC (THF): Mp (UV) = 124000, D = 1,66, Säurezahl = 113 mg KOH/g, Iodzahl = 52,6 g I₂/100 g
**3** S-I-S-MAA (22/16/22/40 %), Ausbeute = 99/100 %, GPC (THF): Mp (UV) = 68000, D = 1,59, Säurezahl = 217 mg KOH/g, Iodzahl = 38,3 g I₂/100 g
**4** S-I-S-MAA (32/32/22/4 %), Ausbeute = 99/100 %, GPC (THF): Mp (UV) = 204000, D = 1,52, Säurezahl = 17 mg KOH/g, Iodzahl = 118 g I₂/100 g
**5** S-I-S-MAA (8/64/8/20 %), Ausbeute = 89/95 %, GPC (THF): Mp (UV) = 112000, D = 1,68, Säurezahl = 111 mg KOH/g, Iodzahl = 195 g I₂/100 g

### Herstellungsbeispiele für Offsetdruckplatten

### Beispiel 1

Eine 8%ige Lösung in 120 ml Tetrahydrofuran aus folgenden Komponenten
4,80 g Blockcopolymer 1, hergestellt in Cyclohexan/ THF,
4,00 g Trimethylolpropan-triacrylat,
0,70 g Dimethylaminpropylmethacrylamid,
0,15 g Benzildimethylketal,
0,05 g 2,6-Di-tert.-butyl-4-methyl-phenol und
0,01 g Fettschwarz HB
wurde auf einen 0,3 mm starken in Salpetersäure aufgerauhten, in Schwefelsäure anodisierten und mit einer 0,1%igen wäßrigen Lösung von Polyvinylphosphonsäure nachbehandelten Aluminiumträger aufgegebracht. Das Schichtgewicht betrug 3,20 g/m². Die Platte wurde anschließend mit einer 3,5%igen wäßrigen Lösung eines Polyalkylenoxid-Polyvinylalkohol-Pfropfpolymeren (Hoechst: ^{(R)}Mowiol 04/M1) überzogen (Schichtgewicht nach dem Trocknen ca. 0,8 g/m²). Die erhaltene Druckplatte wurde mit einer 5-kW-Metallhalogenidlampe im Abstand von 110 cm 40 s unter einem Belichtungskeil sowie verschiedenen anderen Testelementen aus Mikrolinien und Spitzpunktfeldern belichtet. Nach der Belichtung wurde Wasser mit einem Plüschtampon auf der Platte verteilt und damit entwickelt.

Die nichtbelichteten Schichtbereiche wurden innerhalb weniger Sekunden sauber entfernt, wobei eine Kopie mit sehr hoher Auflösung und guter Farbannahme erhalten wurde.

### Beispiele 2 bis 4

Die Offsetdruckplatten gemäß den Beispielen 2 bis 4 wurden in der gleichen Weise mit den Blockcopolymeren 1 (hergestellt in Toluol/THF) bzw. 2 oder 3 produziert. Die Schichtgewichte betrugen bei den Beispielen 2 = 4,81 g/m², 3 = 3,12 g/m² und 4 = 1,75 g/m². Während die Entwicklung der Platte gemäß Beispiel 2 allein mit Wasser erfolgte, wurde bei den Beispielen 3 und 4 eine schwach alkalische, wäßrige Tensidlösung mit einem Gehalt an Kaliumtetraborat verwendet.

### Beispiel 5

Eine Beschichtungslösung aus
6,59 g Blockcopolymer 1, hergestellt in Toluol/THF,
6,59 g Trimethylolpropan-triacrylat,
0,12 g Phenylacridin,
0,14 g Samaronmarineblau HR (Disperse Blue 290),
0,12 g Dibenzalaceton in
130 g 1:19-Mischung aus Propylenglykolmethylether/THF
wurde auf einen 0,3 mm starken in Salpetersäure aufgerauhten, in Schwefelsäure anodisierten und mit einer 0,1%igen wäßrigen Lösung von Polyvinylphosphonsäure nachbehandelten Aluminiumträger aufgebracht. Das Schichtgewicht betrug 4,2 g/m². Die Platte wurde anschließend mit einer 3,5%igen wäßrigen Lösung eines Polyalkylenoxid-Polyvinylalkohol-Pfropfpolymeren (Hoechst: ^{(R)}Mowiol 04/M1) überzogen (Schichtgewicht nach dem Trocknen 0,8 g/m²). Die erhaltene Druckplatte wurde mit einer 5-kW-Metallhalogenidlampe im Abstand von 110 cm 40 s unter einem Belichtungskeil sowie verschiedenen anderen Testelementen aus Mikrolinien und Spitzpunktfeldern belichtet. Nach der Belichtung wurde die Platte mit einem Entwickler (schwach alkalische, wäßrige Tensidlösung mit einem Gehalt an Kaliumtetraborat) mit einem Plüschtampon behandelt.

Die nichtbelichteten Schichtbereiche wurden innerhalb weniger Sekunden sauber entfernt, wobei eine Kopie mit sehr hoher Auflösung und guter Farbannahme erhalten wurde.

### Beispiele 6 und 7

Die Offsetdruckplatten gemäß den Beispielen 6 und 7 wurden in der gleichen Weise mit dem Blockcopolymeren 5 hergestellt. In Beispiel 6 war das Mischungsverhältnis Dowanol:Tetrahydrofuran 1:19, der Feststoffgehalt betrug insgesamt 7,3 % und das Schichtgewicht 1,24 g/m². In Beispiel 7 war das Mischungsverhältnis 1:8, der Feststoffgehalt betrug insgesamt 15 % und das Schichtgewicht 6,65 g/m².

## Patentansprüche

1. Amphiphile, elastomere Blockcopolymerisate, bestehend aus
A 20 bis 99 Gew.-% eines hydrophoben weichen Blocks mit einer Glastemperatur T_{g} von unter -30 °C,
B 30 bis 60 Gew.-% eines hydrophilen harten Blocks mit einer Glastemperatur T_{g} von über +30 °C, der saure Gruppen, vorzugsweise Carboxygruppen, enthält,
C 0 bis 79 Gew.-% eines hydrophoben harten Blocks mit einer Glastemperatur T_{g} von über +50 °C und
X einer Einheit, gebildet aus einer Verbindung mit zwei oder mehreren Vinyl- oder Isopropenylgruppen oder einem aus solchen Verbindungen entstandenen Homopolymerisat-Block, der in der Regel verzweigt bzw. vernetzt ist, wobei das Verhältnis der Gewichtsprozente der Blöcke A zur Summe der Gewichtsprozente der Blöcke B und C 1:0,5 bis 1:19 beträgt.

2. Blockcopolymerisate nach Anspruch 1, dadurch gekennzeichnet, daß die weichen Polymerblöcke A aus konjugierten Dienen, die harten Polymerblöcke B aus ethylenisch α,β-ungesättigten Carbonsäuren und die harten Polymerblöcke C aus Vinylaromaten gebildet sind.

3. Blockcopolymerisate nach Anspruch 2, dadurch gekennzeichnet, daß das konjugierte Dien 1,3-Butadien, Isopren oder 2,3-Dimethyl-1,3-butadien ist.

4. Blockcopolymerisate nach Anspruch 2, dadurch gekennzeichnet, daß die ethylenisch α,β-ungesättigte Carbonsäure Acrylsäure oder Methacrylsäure ist.

5. Blockcopolymerisat nach Anspruch 2, dadurch gekennzeichnet, daß der Vinylaromat Styrol ist.

6. Blockcopolymerisat nach Anspruch 1, dadurch gekennzeichnet, daß der Block X aus 1,4-Divinylbenzol, 1,3-Diisopropenylbenzol, Ethylenglykoldimethacrylat und Trimethylolpropantrimethacrylat aufgebaut ist.

7. Verfahren zur Herstellung der Blockcopolymerisate nach Anspruch 1 bis 6, dadurch gekennzeichnet, daß man die Polymerblöcke durch anionische Polymerisation aufbaut.

8. Lichtempfindliches Gemisch mit mindestens einem Bindemittel, mindestens einer radikalisch polymerisierbaren, olefinisch ungesättigten Verbindung und mindestens einem Photoinitiator, dadurch gekennzeichnet, daß mindestens eines der Bindemittel einem oder mehreren der Ansprüche 1 bis 6 entspricht.

9. Lichtempfindliches Gemisch nach Anspruch 8, dadurch gekennzeichnet, daß der Anteil an Bindemittel(n) 20 bis 95 Gew.-%, bevorzugt 30 bis 90 Gew.-%, bezogen auf die nichtflüchtigen Anteile des Gemisches, beträgt.

10. Lichtempfindliches Gemisch nach Anspruch 8 oder 9, dadurch gekennzeichnet, daß der Anteil der radikalisch polymerisierbaren, olefinisch ungesättigten Verbindung 5 bis 70 Gew.-%, bevorzugt 20 bis 70 Gew.-%, bezogen auf die nichtflüchtigen Bestandteile des Gemisches, beträgt.

11. Lichtempfindliches Gemisch nach einem oder mehreren der Ansprüche 8 bis 10, dadurch gekennzeichnet, daß der Anteil des Photoinitiators 0,1 bis 15 Gew.-%, bevorzugt 0,5 bis 10 Gew.-%, bezogen auf die nichtflüchtigen Bestandteile des Gemisches, beträgt.

12. Aufzeichnungsmaterial mit einem Träger und einer lichtempfindlichen Schicht, dadurch gekennzeichnet, daß die lichtempfindliche Schicht ein lichtempfindliches Gemisch nach einem oder mehreren der Ansprüche 8 bis 11 enthält.
